Europäisches Patentamt

European Patent Office

Office européen des brevets

(11) Veröffentlichungsnummer: **0 430 060 B1**

(12) **EUROPÄISCHE PATENTSCHRIFT**

(45) Veröffentlichungstag der Patentschrift: **09.03.94**

(51) Int. Cl.⁵: **G01R 15/07**

(21) Anmeldenummer: **90122279.4**

(22) Anmeldetag: **22.11.90**

(54) **Faseroptischer Stromwandler.**

(30) Priorität: **01.12.89 CH 4279/89**

(43) Veröffentlichungstag der Anmeldung:
**05.06.91 Patentblatt 91/23**

(45) Bekanntmachung des Hinweises auf die
Patenterteilung:
**09.03.94 Patentblatt 94/10**

(84) Benannte Vertragsstaaten:
**CH DE ES FR GB IT LI SE**

(56) Entgegenhaltungen:
**EP-A- 0 072 292**
**DE-A- 2 924 804**
**DE-A- 3 115 433**
**FR-A- 2 485 204**

(73) Patentinhaber: **ASEA BROWN BOVERI AG**

**CH-5401 Baden(CH)**

(72) Erfinder: **Brändle, Hubert, Dr.**
**Bahnhofstrasse 34**
**CH-8112 Otelfingen(CH)**
Erfinder: **Stierlin, Roland, Dr.**
**Leerber 4**
**CH-5722 Gränichen(CH)**

## Beschreibung

Die Erfindung betrifft einen faseroptischen Stromwandler, umfassend

a) eine Sensorspule mit einer Sensorfaser zum Detektieren eines Stroms mittels des Faraday-Effekts,

b) eine Lichtquelle zum Erzeugen von Licht,

c) faseroptische Mittel zum Zu- und Wegführen von Licht,

d) Mittel zum Polarisieren des zugeführten Lichts,

e) einen Y-Verzweiger an einem Einkopplungsende der Sensorfaser,

f) einen Spiegel an einem entfernten Ende der Sensorfaser, und

g) Mittel zum Detektieren einer magneto-optisch induzierten Drehung der Polarisationsrichtung des Lichts.

## Stand der Technik

Im Zusammenhang mit Starkstromanwendungen haben faseroptische Sensoren wegen ihren bekannten Eigenschaften (passive Sensoren, inhärente galvanische Trennung, nicht-invasive Messonden, geringes Gewicht, kleiner Volumenbedarf, einfache Integration in digitale Systemüberwachung) gegenüber herkömmlichen Messvorrichtungen beträchtliche Vorteile. Aus der Literatur sind verschiedene Prototypen bekannt. Eine neuere Analyse integrierter, magneto-optischer Sensoren liefert z.B. der Artikel "Magneto-optical fibre sensors for electrical industry: Analysis and performances", S. Donati, V. Annovazzi-Lodi, T. Tambosso, IEEE Proc. Vol. 135, Pt. J. No. 5, October 1988, pp. 372-383.

Ein passiver faseroptischer Stromwandler der eingangs genannten Art ist z.B. aus DE-A-31 15 433 bekannt. Dieser Stromwandler benutzt den Faraday-Effekt, der in einer Sensorfaser eine zirkulare Doppelbrechung induziert. Die Sensorfaser ist dabei in mehreren Wicklungen um den Stromleiter geführt. Sie ist um ihre Längsachse stark verdrillt, so dass die krümmungsinduzierte und die lineare innere Doppelbrechung der Faser unterdrückt werden. Die Sensorfaser wird in Reflexion betrieben. An ihrem Einkopplungsende befindet sich eine Y-Verzweigung mit je einem Arm zum Ein- und zum Auskoppeln von linear polarisiertem Licht. Die Detektion erfolgt polarimetrisch.

Das Prinzip der polarimetrischen Detektion ist z.B. aus der Veröffentlichung FR-A-2.485.204 bekannt.

Eine zentrale Position im genannten Stromwandler nimmt die Sensorspule ein. Sie kann auf verschiedene Arten implementiert werden. Grundsätzlich geht es jeweils darum, unerwünschte Doppelbrechungseffekte zugunsten des Faraday-Effekts zu unterdrücken. Wie sich dieses Ziel erreichen lässt ist z.B. aus den Artikeln

- "Development of low- and high-birefringence optical fibres", D.A. Payne et al., IEEE J. of Quant. Electronics, QE-18 (1982), pp. 477-488,
- "The rotation of the polarization in low-birefringence optical monomode fibres due to geometrical effects", J.N. Ross, Optical and Quantum Electronics 16 (1984), pp. 455-461,
- "Current sensors using highly birefingent bow-tie fibers", L. Li et al., Electronics Lett. 22 (1986), p. 1142-1144 bekannt.

Zwar sind die Wege zur Implementierung der faseroptischen Sensoren ihrer Richtung nach vorgezeichnet. Nach wie vor ist aber unklar, wie Langzeitstabilität, Betriebssicherheit und hohe Messgenauigkeit im konkreten Anwendungsfall, d.h. unter den tatsächlichen, oft rauhen Umgebungsbedingungen (z.B. in einer Stromverteilzentrale) gewährleistet werden können. Speziell mechanische Einwirkungen (Vibrationen) und Temperaturänderungen können je nach Aufbau des Stromwandlers erhebliche Störungen verursachen.

Grundsätzlich ist es wünschenswert, möglichst wenige Einzelelemente zu verwenden. Aus dieser Sicht ist es deshalb von Bedeutung, dass bereits Laserdiodenmodule entwickelt worden sind (siehe z.B. "Efficient highly stable laser diode module for single mode fiber employing a combination of hemispherical ended GRIN rod lens and virtual fiber", K. Kawano et al., applied optics, Vol. 28 No. 11, 1 June 1989, pp. 2012-2016), die unmittelbar an einem Ende einer Singlemodefaser (SMF) befestigt sind und sich dementsprechend durch eine gute Kopplungseffizienz, mechanische Robustheit und geringe Kosten auszeichnen.

## Darstellung der Erfindung

Aufgabe der Erfindung ist es, einen faseroptischen Stromwandler der eingangs genannten Art anzugeben, welcher die beim Stand der Technik vorhandenen Probleme vermeidet und sich für die Anwendung unter rauhen Umgebungsbedingungen eignet.

Erfindungsgemäss besteht die Lösung darin, dass bei einem Stromwandler der genannten Art

- zwischen Lichtquelle und Y-Verzweiger eine erste HB-Faser das Mittel zum Zuführen von licht bildet,
- zwischen Y-Verzweiger und den Mitteln zum Detektieren eine zweite HB-Faser als das Mittel zum Wegführen von licht vorgesehen ist, wobei die zweite HB-Faser mit ihren Doppelbrechungsachsen um 45° gegenüber den Doppelbrechungsachsen der ersten HB-Faser gedreht ist und

- am Ende der ersten HB-Faser vor oder in dem eigentlichen Y-Verzweiger die Mittel zum Polarisieren des Lichts parallel zu einer durch die erste HB-Faser vorgegebenen Doppelbrechungsachse vorgesehen sind.

Die Vorteile der Erfindung sind der einfache optische Aufbau und die Unempfindlichkeit gegen Temperatur- und Vibrationseinflüsse. Die erfindungsgemässe Vorrichtung erfordert nämlich keine neuartigen Komponenten, sondern lässt sich mit komerziell erhältlichen Bauelementen realisieren. Daneben ist die Zahl der optischen Elemente gering gehalten. Dies ist deshalb von Wichtigkeit, weil jede Verbindung von Bauteilen eine Verminderung der Signalqualität zur Folge hat und zudem den herstellungstechnischen Aufwand vergrössert.

Einen wichtigen Beitrag zur Robustheit des Stromwandlers leistet die separate Zu- und Wegführung des Lichts zum und vom Sensor in stark doppelbrechenden Glasfasern, kurz HB-Fasern (HB = High Birefringence) genannt. Ein wesentlicher Aspekt ist dabei die 45°-Orientierung der wegführenden HB-Faser in bezug auf die Doppelbrechungsachsen der zuführenden HB-Faser.

Die erfindungsgemässe 45°-Orientierung ermöglicht es, die Vorteile der polarimetrischen Detektion (insbesondere ihren einfachen Aufbau und ihre Präzision) voll zu nutzen, und zugleich die Sensorspule von der Detektion örtlich zu trennen. Dies ist beispielsweise bei Strommessungen an Freileitungen von besonderer Bedeutung. Die 45°-Orientierung in Verbindung mit der Doppelbrechungseigenschaft der (wegführenden) Faser und nachfolgendem Wollastonprisma, dessen Achsen auf die Doppelbrechungsachsen der zweiten HB-Faser ausgerichtet sind, hat im Prinzip dieselbe Funktion wie eine polarimetrische Detektion unmittelbar am Ende der Sensorfaser.

Ein zentrales Element der erfindungsgemässen Anordnung ist der Y-Verzweiger. Er sollte entweder doppelbrechungsfrei sein oder eine Länge aufweisen, die aufgrund der vorhandenen Doppelbrechung zu einer optischen Verzögerung von gerade 180° resp. einem ganzzahligen Vielfachen davon führt.

Der Y-Verzweiger besteht vorzugsweise aus einem Glassubstrat, in welches geeignete, Y-förmige Wellenleiterbahnen eindiffundiert sind. Ein solcher Y-Verzweiger kann auch im polarimetrischen Detektor zum Aufspalten der Polarisationsmoden der wegführenden HB-Faser verwendet werden. Die Polarisationsmoden werden dabei an den Armen des Y-Verzweigers von zwei orthogonal zueinander ausgerichteten Polarisatoren analysiert und dann von Photodioden detektiert.

Eine derartige Ausführungsform hat den Vorteil, dass keine offenen Strahlengänge (wie etwa bei Verwendung eines Wollastoneprismas oder eines Beamsplitters) auftreten. Dies hat nicht nur eine hohe Integration zur Folge, sondern auch eine gute mechanische Robustheit. Beim Aufbau des optischen Teils eines erfindungsgemässen Stromwandlers reduzieren sich die Probleme im wesentlichen auf das Verspleissen von Glasfasern.

Gemäss einer bevorzugten Ausführungsform der Erfindung ist die spektrale Bandbreite der Lichtquelle so gross, dass die Kohärenzlänge des Lichts in der Grössenordnung von 100 $\mu$m liegt. Dies hat zur Folge, dass eine unerwünschte Ueberkopplung der Polarisationszustände in den HB-Fasern gering ist.

Zu den im erwähnten Sinn bevorzugten Lichtquellen gehören insbesondere Leuchtdioden (LED oder SRD), aber auch Laserdioden (LD) mit mehreren axialen Moden. Sie haben spektrale Bandbreiten im bevorzugten Bereich von 5 - 50 nm.

Wenn am entfernten Ende der Sensorfaser ein Drehspiegel angeordnet ist, dann können die störenden Einflüsse verringert werden, die z.B. durch das Fixieren der verdrillten Sensorfaser auftreten können. Ein Drehspiegel wird z.B. gebildet durch einen zwischen dem entfernten Ende der Sensorfaser und dem Spiegel angeordneten Faraday-Rotator, der eine totale Rotation der Polarisationsrichtung um 90° bewirkt,

Ein Drehspiegel umfasst vorzugsweise ein optisches Glas, das in einem Permanentmagneten untergebracht ist, sowie eine Optik (z.B. eine Sammellinse) zum Kollimieren des aus der Sensorfaser in das optische Glas übertretenden Lichts. Das optische Glas ist z.B. direkt an einem Ende verspiegelt.

Zur Optimierung der Polarisationsrichtung des Lichts, das in den Y-Verzweiger eingekoppelt wird, ist am Ende der zuführenden HB-Faser vor der eigentlichen Y-Verzweigung ein Polarisator angeordnet. Vorzugsweise wird dieser durch eine in an sich bekannter Weise zu einem faseroptischen Polarisator geschlauften Ende der HB-Faser oder durch einen integriert optischen Polarisator in einem Arm des Y-Verzweigers gebildet. Auf diese Art werden zusätzliche, separate Bauelemente vermieden.

Gemäss einer vorteilhaften Ausführungsform ist die Lichtquelle eine direkt auf das Ende der zuführenden Faser aufgeklebte Leucht- oder Laserdiode ("Pigtail"). Eine solche Auführungsform ist mechanisch robust und erlaubt eine hohe Integrationsdichte mit wenig einzelnen Bauteilen.

Die Sensorspule wird mit Vorteil wie folgt realisiert:

- Aufwickeln einer Glasfaser mit hoher intrinsischer zirkularer Doppelbrechung (z.B. "HB-spun fiber") auf einen Hohlzylinder, oder

- Tordieren und loses Aufwickeln einer Glasfaser mit geringer linearer Doppelbrechung auf einen Hohlzylinder, oder
- Aufwickeln einer Glasfaser, in der das Licht auf einer Schraubenlinie geführt wird.

Der Y-Verzweiger wird vorzugsweise auf dem Hohlzylinder der Sensorspule fixiert und zwar so, dass die Sensorfaser zwischen aufgewickeltem Abschnitt und Y-Verzweiger in tangentialer Richtung verläuft.

Weitere vorteilhafte Ausführungsformen ergeben sich aus den verschiedenen Kombinationsmöglichkeiten der einzelnen Merkmale.

## Kurze Beschreibung der Zeichnungen

Nachfolgend soll die Erfindung anhand von Ausführungsbeispielen und im Zusammenhang mit den Zeichnungen näher erläutert werden. Es zeigen:

Fig. 1    eine schematische Darstellung eines faseroptischen Sensors;

Fig. 2    eine schematische Darstellung eines Y-Verzweigers;

Fig. 3    eine schematische Darstellung eines Drehspiegels; und

Fig. 4    eine schematische Darstellung eines an der Sensorspule befestigten Y-Verzweigers.

Die in den Zeichnungen verwendeten Bezugszeichen und deren Bedeutung sind in der Bezeichnungsliste zusammenfassend aufgelistet. Grundsätzlich sind in den Figuren gleiche Teile mit gleichen Bezugszeichen versehen.

## Wege zur Ausführung der Erfindung

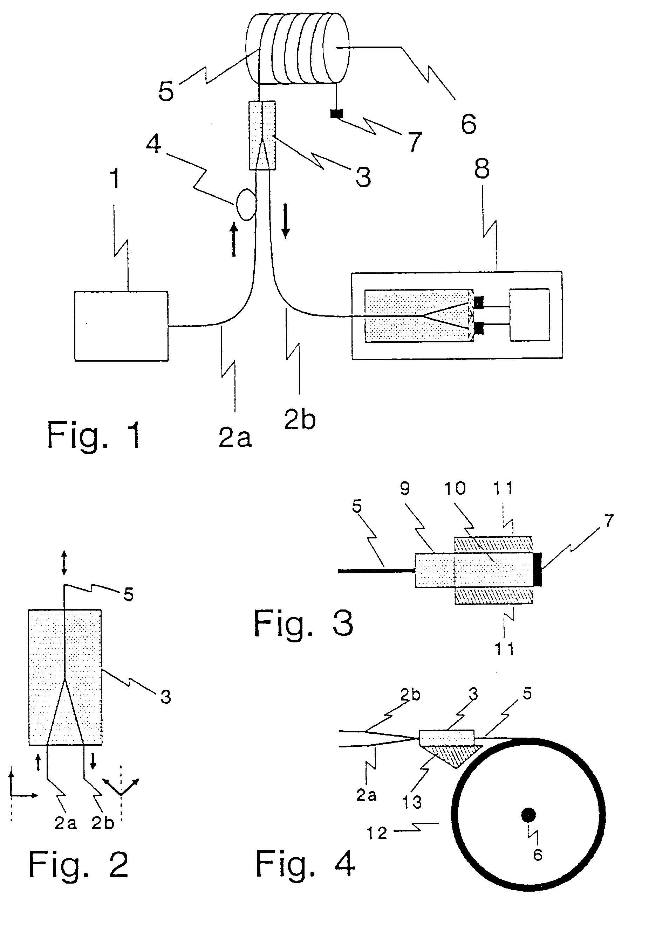

Fig. 1 zeigt schematisch einen faseroptischen Stromwandler. Eine Lichtquelle 1 ist unmittelbar an einer ersten HB-Faser 2a angeschlossen.

Gemäss einer bevorzugten Ausführungsform ist die Lichtquelle 1 eine Leuchtdiode vom Typ einer herkömmlichen LED, eine Super Luminescent Diode (siehe z.B. im zitierten Artikel von S. Donati et al.) oder eine multimode Laserdiode. Die LED, SRD resp. LD ist jeweils direkt an ein Ende der ersten HB-Faser 2a angeklebt ist ("Pigtail"). Um eine optimale Einkopplung zu erhalten sollte die strahlende Fläche der Leuchtdiode z.B. nicht mehr als etwa 10 - 20 $\mu$m Abstand von der HB-Faser 2a haben oder aber über ein Linsensystem auf das Faserende abgebildet werden. Einzelheiten sind z.B. dem bereits zitierten Artikel von K. Kawano zu entnehmen.

Sowohl LED als auch Super Luminescent Diode, kurz SRD genannt, haben eine grosse spektrale Bandbreite, wie es im Sinn der Erfindung wünschenswert ist. Die grosse spektrale Bandbreite hat nämlich eine erstrebte geringe Kohärenzlänge zur Folge. Damit wird ein Uebersprechen der Polarisationszustände in der HB-Faser weitgehend unterdrückt.

Vorzugsweise ist die Kohärenzlänge kleiner als 1 mm. Typischerweise liegt sie in der Grössenordnung von etwa 100 $\mu$m. In bezug auf die spektrale Bandbreite wird ein Bereich von 5 - 50 nm als wünschenswert betrachtet.

Die HB-Faser 2a führt zu einem idealerweise optisch isotropen Y-Verzweiger 3. Kurz vor diesem weist die HB-Faser 2a gemäss einer bevorzugten Ausführungsform einen faseroptischen Polarisator 4 auf. Dieser wird in bekannter Weise dadurch gebildet, dass das Ende der HB-Faser 2a unter einem bestimmten Radius zu einer engen Schlaufe gewickelt ist. Der Polarisator 4 sorgt dafür, dass die in den Y-Verzweiger (resp. in die nachfolgende Sensorfaser) eingekoppelte Polarisationsrichtung des Lichts genau definiert und frei von übertragungsbedingten Mischzuständen ist.

Der Y-Verzweiger 3 hat drei lichtleitende Arme. Ueber einen ersten Arm wird Licht aus der ersten HB-Faser 2a zugeführt. Ein gegenüberliegender zweiter Arm bildet den Ein- resp. Ausgang zu resp. von einer Sensorfaser 5. Ein verbleibender dritter Arm, der dem zweiten Arm gegenüberliegt und dem ersten benachbart ist, ist an eine wegführende zweite HB-Faser 2b angekoppelt.

Eine zentrale Eigenschaft des Y-Verzweigers ist seine Doppelbrechungsfreiheit oder zumindest seine Doppelbrechungsarmut. Im Fall der optischen Isotropie (Abwesenheit von Doppelbrechung) wird der Polarisationszustand aus der ersten HB-Faser 2a ungestört an die Sensorfaser 5 abgegeben.

Falls eine geringe Doppelbrechung vorhanden ist, ergibt sich eine geringe temperaturabhängige Störung der Polarisationszustände, was die Messgenauigkeit beeinträchtigt. In diesem Fall wird durch eine Längenanpassung des Y-Verzweigers erreicht, dass die optische Verzögerung (Phasenunterschied) gerade 180° (oder ein ganzzahliges Vielfaches davon) beträgt. Dadurch bleibt ein linearer Eingangspolarisationszustand erhalten. Beim Durchgang durch den Y-Verzweiger wird somit nur gerade die Richtung der linearen Polarisation gedreht.

Wenn der Y-Verzweiger 3 doppelbrechend ist, dann müssen seine Achsen auf die Doppelbrechungsachsen der zuführenden ersten HB-Faser ausgerichtet werden.

Der Y-Verzweiger 3 ist vorzugsweise integriert optisch ausgeführt, indem beispielsweise in einem geeigneten Glassubstrat durch Ionentausch selektiv der Brechungsindex erniedrigt wird, so dass flach verzweigende, Y-förmige Wellenleiterbahnen entstehen.

Alternativ kann auch ein (allenfalls schwach doppelbrechender) faseroptischer Richtkoppler verwendet werden. Einem integriert optischen Y-Verzweiger ist jedoch den Vorzug zu geben, weil er die erfindungsgemässe Vorrichtung insgesamt weniger störempfindlich macht.

Bei einem integriert optischen Y-Verzweiger können die Mittel zur Polarisation vorzugsweise ebenfalls integriert optisch, d.h. auf einem gemeinsamen Substrat mit dem Y-Verzweiger, ausgebildet werden und ersetzen dann den faseroptischen Polarisator 4. In der Ausführungsform gemäss Fig. 1 wäre der erste Arm des Y-Verzweigers polarisierend ausgebildet. Es versteht sich dabei, dass die Polarisationsrichtung und die Doppelbrechungsachsen der ersten HB-Faser aufeinander ausgerichtet sein müssten.

Den eigentlichen Messwandler bildet eine Sensorspule, die als wesentlichstes Element eine Sensorfaser umfasst, wie sie im folgenden erörtert wird.

Die bereits erwähnte Sensorfaser 5 führt z.B. in mehreren Wicklungen um einen Stromleiter 6 (z.B. eine elektrische Freileitung) herum. An einem entfernten Ende der Sensorfaser 5 ist ein Spiegel 7 angeordnet. Darunter sind ganz allgemein irgendwelche geeignete Mittel zu verstehen, die das zum entfernten Ende der Sensorfaser 5 kommende Licht zurückreflektieren. Insbesondere gehören dazu dielektrische oder metallische Verspiegelungen des Faserendes.

Das reflektierte und dann aus dem Einkopplungsende der Sensorfaser 5 austretende Licht wird durch den Y-Verzweiger 3 an die wegführende, zweite HB-Faser 2b übertragen und schliesslich an einen nachfolgenden polarimetrischen Detektor 8 abgegeben.

Der polarimetrische Detektor 8 arbeitet in an sich bekannter Weise. Er detektiert die Intensitäten $I_1$ und $I_2$ der zwei Polarisationsmoden der zweiten HB-Faser 2b und ermittelt aus dem Verhältnis $(I_1 - I_2)/(I_1 + I_2)$ den im Stromleiter 6 fliessenden elektrischen Strom.

Vorzugsweise wird im polarimetrischen Detektor 8 ein Y-Verzweiger in Verbindung mit zwei senkrecht zueinander ausgerichteten Polarisatoren verwendet, die an den Ausgängen der Arme je einen Polarisationszusatnd der zweiten HB-Faser analysieren. In bezug auf die Doppelbrechung gilt dasselbe, was bereits oben zum Y-Verzweiger gesagt worden ist. Bei Doppelbrechung ist der Y-Verzweiger des Detektors auf die Doppelbrechungsachsen der zweiten HB-Faser auszurichten.

Die zweite HB-Faser 2b ist auf ganz bestimmte Weise, d.h. mit einer wohldefinierten Orientierung am Y-Verzweiger 3 angeschlossen. Dies soll im folgenden anhand von Fig. 2 erläutert werden.

Bekanntlich kann einer HB-Faser ein orthogonales Koordinatensystem mit zwei Achsen zugeordnet werden. Die genannten Achsen entsprechen dabei den Doppelbrechungsachsen der HB-Faser. In Fig. 2 sind diese Kordinatensysteme für die beiden HB-Fasern 2a und 2b angedeutet. Gemäss der Erfindung ist das Koordinatensystem der zweiten HB-Faser 2b gegenüber demjenigen der ersten HB-Faser 2a um 45° gedreht. Dies hat folgende Wirkung.

Bei Abwesenheit eines elektrischen Stroms (Ruhezustand) liegt die Polarisationsrichtung (angedeutet durch eine gestrichelte Linie) des aus der ersten HB-Faser 2a austretenden Lichts parallel zu einer Doppelbrechungsachse. Nach dem Durchgang durch die Sensorfaser d.h. beim Eintritt in die wegführende zweite HB-Faser 2b fällt die Polarisationsrichtung mit der Winkelhalbierenden des Koordinatensystems derselben zusammen.

Bei Anwesenheit eines Wechselstromes im Stromleiter 8 schwankt die Polarisationsrichtung beim Eingang in die zweite HB-Faser 2b periodisch um die Winkelhalbierende. In der zweiten HB-Faser wird also das Licht intensitätsmässig ungefähr zu gleichen Anteilen auf die beiden Polarisationszustände aufgeteilt. Dies bedeutet für die nachfolgende polarimetrische Detektion maximale Empfindlichkeit.

Als nächstes soll auf die Sensorspule näher eingegangen werden. Sie wird vorzugsweise durch eine Sensorfaser 5 gebildet, die auf einen geeigneten Hohlzylinder z.B. aus Kunststoff aufgewickelt ist. In der Praxis stehen für die Realisierung mehrere Wege offen.

Die Sensorfaser kann z.B. eine Glasfaser mit hoher intrinsischer zirkularer Doppelbrechung sein (z.B. "HB-spun fiber"). Sie wird lose auf den Hohlzylinder aufgewickelt. Diese Technik ist z.B. aus dem eingangs zitierten Artikel von L. Li et al. bekannt.

Eine andere Möglichkeit besteht darin, eine Glasfaser mit geringer linearer Doppelbrechung zu verwenden. Dabei ist es erforderlich, die Glasfaser zuerst mechanisch zu tordieren und dann auf den Hohlzylinder aufzuwickeln. In diesem Fall muss die Sensorfaser also an beiden Enden gut am Hohlzylinder fixiert sein, damit die Verdrillung bestehen bleibt. Dies kann Nachteile mit sich bringen, die sich aber mit bestimmten, noch zu beschreibenden Mitteln vermeiden lassen. Die Verwendung einer verdrillten Glasfaser als Stromwandler ist vom Prinzip her z.B. aus der bereits zitierten Patentschrift DE-A-31 15 433 bekannt.

Eine dritte Variante ist die Verwendung einer Glasfaser, in der das Licht auf einer Schraubenlinie geführt wird. Die Glasfaser wird lose auf den Hohlzylinder aufgewickelt. Eine solche Technik ist z.B. aus dem eingangs zitierten Artikel von J.N. Ross bekannt.

Fig. 3 zeigt eine Erweiterung der Sensorspule, die insbesondere im Zusammenhang mit verdrillten Glasfasern von Interesse ist. Es handelt sich bei der Erweiterung um einen Faraday-Rotator, der am entfernten Ende der Sensorfaser 5 zwischen Faserende und Spiegel 7 angeordnet ist.

Das aus der Sensorfaser 5 am entfernten Ende (aus der Sicht des Y-Verzweigers 3) austretende Licht wird mit einer geeigneten Optik, z.B. einer Linse 9, kollimiert und durchsetzt dann in axialer Richtung ein zylinderförmiges optisches Glas 10. Hinter dem optischen Glas 10 befindet sich der Spiegel 7, so dass das Licht das optische Glas 10 ein zweites Mal in umgekehrter Richtung durchsetzt und von der Linse 9 wieder in die Sensorfaser 5 eingekoppelt wird.

Ein aussen am optischen Glas 10 angeordneter Permanentmagnet 11 bewirkt mit Hilfe des magneto-optischen Effekts, dass die Polarisationsrichtung des Lichts nach zweimaligem Durchgang (hin und zurück) um 90° gedreht ist. Der Vorteil dieser 90°-Rotation liegt darin, dass induzierte Doppelbrechungen, die z.B. durch die stabile Fixierung der verdrillten Glasfaser hervorgerufen werden können, weitgehend eliminiert werden können.

Zwar wird der Drehspiegel (z.B. Faraday-Rotator mit einem verspiegelten Ende) vorzugsweise zusammen mit der tordierten Sensorfaser verwendet. Dies will aber nicht heissen, dass er nicht auch bei anderen Ausführungsarten der Sensorspule Vorteile bringen kann. Es versteht sich, dass der Faraday-Rotator auch in anderer Weise aufgebaut sein kann, solange nur die 45°-Drehung pro Durchgang gewährleistet ist.

Fig. 4 zeigt eine schematische Darstellung eines an der Sensorspule befestigten Y-Verzweigers 3. Die Sensorfaser 5 ist wie oben beschrieben auf einen Hohlzylinder 12 aus Kunststoff aufgewickelt. Eingangsseitig ist sie an den zweiten Arm des Y-Verzweigers 3 angeschlossen. Gemäss einer vorteilhaften Ausführungsform ist nun der Y-Verzweiger 3 an der Sensorspule, genauer gesagt am Hohlzylinder 12 befestigt. Dabei ist er so ausgerichtet, dass die Sonsorfaser 5 tangential vom Hohlzylinder wegstrebt und das Licht den Y-Verzweiger 3 auf einer ungebrochenen Linie durchsetzen kann. Die genannte Bedingung kann beispielsweise mit Hilfe eines kleinen Keils 13 zwischen Y-Verzweiger 3 und Hohlzylinder 12 gewährleistet werden.

Zu den wesentlichen Merkmalen der Erfindung zählt sicher die Zu- und Wegführung des Lichts über HB-Fasern, sowie deren spezielle Verbindung mit dem Y-Verzweiger. Die einzelnen Aspekte sind ansonsten vielen Abwandlungen zugänglich. Diese ergeben sich für den Fachmann in zwangsloser Weise aus den erörterten Ausführungsbeispielen.

Wie bereits mehrfach angedeutet, eignet sich der erfindungsgemässe Stromwandler besonders gut für Strommessungen an elektrischen Freileitungen.

Zusammenfassend kann festgehalten werden, dass die Erfindung einen Weg angibt, wie faseroptische Stromwandler für den praktischen Einsatz in rauher Umgebung auszubilden sind.

## BEZEICHNUNGLISTE

1 - Lichtquelle; 2a, 2b - HB-Faser; 3 - Y-Verzweiger; 4 - Polarisator; 5 - Sensorfaser; 6 - Stromleiter; 7 - Spiegel; 8 - Detektor; 9 - Linse; 10 - optisches Glas; 11 - Permanentmagnet; 12 - Hohlzylinder; 13 - Keil.

## Patentansprüche

1. Faseroptischer Stromwandler, umfassend
   a) eine Sensorspule mit einer Sensorfaser (5) zum Detektieren eines Stroms mittels des Faraday-Effekts,
   b) eine Lichtquelle (1) zum Erzeugen von Licht,
   c) faseroptische Mittel zum Zu- und Wegführen von Licht,
   d) Mittel zum Polarisieren des zugeführten Lichts (4),
   e) einen Y-Verzweiger (3) an einem Einkopplungsende der Sensorfaser,
   f) einen Spiegel (7) an einem entfernten Ende der Sensorfaser, und
   g) Mittel zum Detektieren (8) einer magneto-optisch induzierten Drehung der Polarisationsrichtung des Lichts, dadurch gekennzeichnet, dass
   h) zwischen Lichtquelle (1) und Y-Verzweiger (3) eine erste HB-Faser (2a) das Mittel zum Zuführen von licht bildet,
   i) zwischen Y-Verzweiger (3) und den Mitteln zum Detektieren (8) eine zweite HB-Faser (2b) als das Mittel zum Wegführen vorgesehen ist, wobei die zweite HB-Faser (2b) mit ihren Doppelbrechungsachsen um 45° gegenüber den Doppelbrechungsachsen der ersten HB-Faser (2a) gedreht ist und
   j) am Ende der ersten HB-Faser (2a) vor oder in dem eigentlichen Y-Verzweiger (3) die Mittel zum Polarisieren des Lichts (4) parallel zu einer durch die erste HB-Faser (2a) vorgegebenen Doppelbrechungsachse vorgesehen sind.

2. Faseroptischer Stromwandler nach Anspruch 1, dadurch gekennzeichnet, dass der Y-Verzweiger (3)

a) entweder doppelbrechungsfrei ist,

b) oder eine Länge aufweist, die aufgrund der vorhandenen Doppelbrechung zu einer optischen Verzögerung von gerade 180° resp. einem ganzzahligen Vielfachen davon führt.

3. Faseroptischer Stromwandler nach Anspruch 2, dadurch gekennzeichnet, dass die Lichtquelle (1) eine spektrale Bandbreite zwischen 5 und 50 nm hat.

4. Faseroptischer Stromwandler nach Anspruch 1, dadurch gekennzeichnet, dass der Spiegel (7) am entfernten Ende der Sensorfaser (5) als Drehspiegel ausgebildet ist, der die Polarisationsrichtung des Lichts um total 90° dreht.

5. Faseroptischer Stromwandler nach Anspruch 1, dadurch gekennzeichnet, dass der Y-Verzweiger (3) zusammen mit den Mitteln zum Polarisieren (4) integriert optisch ausgebildet ist.

6. Faseroptischer Stromwandler nach Anspruch 1, dadurch gekennzeichnet, dass die Mittel zum Polarisieren (4) ein zu einem faseroptischen Polarisator geschlauftes Ende der zuführenden ersten HB-Faser (2a) umfassen.

7. Faseroptischer Stromwandler nach Anspruch 1, dadurch gekennzeichnet, dass die Sensorspule in einer der drei folgenden Arten ausgebildet ist:
   - eine Glasfaser mit hoher intrinsischer zirkularer Doppelbrechung ist lose auf einen Hohlzylinder (12) aufgewickelt, oder
   - eine Glasfaser mit geringer linearer Doppelbrechung ist mechanisch tordiert und lose auf einen Hohlzylinder (12), aufgewickelt, oder
   - eine Glasfaser, in der das Licht auf einer Schraubenlinie geführt wird, ist lose auf einen Hohlzylinder (12) aufgewickelt.

8. Faseroptischer Stromwandler nach Anspruch 1, dadurch gekennzeichnet, dass die Lichtquelle (1) eine LED, eine SRD oder eine LD ist, die jeweils direkt an die erste HB-Faser (2a) angeklebt ist.

9. Faseroptischer Stromwandler nach Anspruch 4, dadurch gekennzeichnet, dass der Drehspiegel im Sinn eines Faraday-Rotators ein optisches Glas (10), das in einem Permanentmagneten (11) untergebracht ist, sowie eine Optik zum Kollimieren des aus der Sensorfaser (5) in das optische Glas (10) übertretenden Lichts umfasst.

10. Faseroptischer Stromwandler nach Anspruch 1, dadurch gekennzeichnet, dass die Mittel zum Detektieren (8) einen Y-Verzweiger mit Polarisatoren an den Armen zum Analysieren der beiden Polarisationszustände der zweiten HB-Faser umfassen.

**Claims**

1. Fibre-optical current transformer, comprising
   a) a sensor coil with a sensor fibre (5) for detecting a current by means of the Faraday effect,
   b) a light source (1) for generating light,
   c) fibre-optical means for supplying and removing light,
   d) means for polarizing the supplied light (4),
   e) a Y splitter (3) at one input end of the sensor fibre,
   f) a mirror (7) at a remote end of the sensor fibre, and
   g) means for detecting (8) a magneto-optically induced rotation of the direction of polarization of the light, characterized in that
   h) a first HB fibre (2a) between light source (1) and Y splitter (3) forms the means for supplying light,
   i) a second HB fibre (2b) is provided between Y splitter (3) and the means for detecting (8) as the means for removing, the second HB fibre (2b) being rotated with its birefringence axes by 45° with respect to the birefringence axes of the first HB fibre (2a), and
   j) the means for polarizing the light (4) in parallel with one birefringence axis predetermined by the first HB fibre (2a) are provided at the end of the first HB fibre (2a) in front of or in the actual Y splitter (3).

2. Fibre-optical current transformer according to Claim 1, characterized in that the Y splitter (3)
   a) is either free of birefringence,
   b) or has a length which, due to the existing birefringence, leads to an optical delay of exactly 180° or an integral multiple thereof, respectively.

3. Fibre-optical current transformer according to Claim 2, characterized in that the light source (1) has a spectral band width of between 5 and 50 nm.

4. Fibre-optical current transformer according to Claim 1, characterized in that the mirror (7) at the remote end of the sensor fibre (5) is constructed as a rotating mirror which rotates the direction of polarization of the light by a total of 90°.

5.  Fibre-optical current transformer according to Claim 1, characterized in that the Y splitter (3), together with the means for polarizing (4), is constructed to be optically integrated.

6.  Fibre-optical current transformer according to Claim 1, characterized in that the means for polarizing (4) comprise an end of the incoming first HB fibre (2a) looped to form a fibre-optical polarizer.

7.  Fibre-optical current transformer according to Claim 1, characterized in that the sensor coil is constructed in one of the three following types:
    -   a glass fibre with a high intrinsic circular birefringence is loosely wound onto a hollow cylinder (12), or
    -   a glass fibre with a low linear birefringence is mechanically twisted and loosely wound onto a hollow cylinder (12), or
    -   a glass fibre, in which the light is conducted along a helical line, is loosely wound onto a hollow cylinder (12).

8.  Fibre-optical current transformer according to Claim 1, characterized in that the light source (1) is an LED, an SRD or an LD which is in each case bonded directly to the first HB fibre (2a).

9.  Fibre-optical current transformer according to Claim 4, characterized in that the rotating mirror in the sense of a Faraday rotator comprises an optical glass (10) which is accommodated in a permanent magnet (11) and optics for collimating the light passing from the sensor fibre (5) into the optical glass (10).

10. Fibre-optical current transformer according to Claim 1, characterized in that the means for detecting (8) comprise a Y splitter with polarizers at the arms for analyzing the two states of polarization of the second HB fibre.

**Revendications**

1.  Transformateur de courant à fibres optiques, comprenant
    a) une bobine détectrice avec une fibre détectrice (5) pour détecter un courant par effet Faraday,
    b) une source de lumière (1) pour la production de lumière,
    c) des moyens à fibres optiques pour amener et renvoyer la lumière,
    d) des moyens pour polariser la lumière amenée (4),
    e) un branchement en Y (3) à une extrémité d'injection de la fibre détectrice,
    f) un miroir (7) à une extrémité éloignée de la fibre détectrice, et
    g) des moyens pour détecter (8) une rotation du sens de polarisation de la lumière, induite magnéto-optiquement,
        caractérisé en ce que
    h) entre la source de lumière (1) et le branchement en Y (3), une première fibre HB (2a) constitue le moyen pour amener la lumière,
    i) une deuxième fibre HB (2b) est prévue entre le branchement en Y (3) et les moyens de détection (8), en tant que moyen pour renvoyer la lumière, dans lequel la deuxième fibre HB (2b) avec ses axes de biréfringence est tournée de 45° par rapport aux axes de biréfringence de la première fibre HB (2a) et
    j) les moyens de polarisation de la lumière (4) sont prévus à l'extrémité de la première fibre HB (2a), en amont ou dans le branchement en Y (3) proprement dit, parallèlement à un axe de biréfringence passant par la première fibre HB (2a).

2.  Transformateur de courant à fibres optiques selon la revendication 1, caractérisé en ce que le branchement en Y (3) est
    a) soit exempt de biréfringence
        ou a une longueur qui, du fait de la biréfringence existante, conduit à un retard optique de précisément 180° ou d'un multiple entier de cette valeur.

3.  Transformateur de courant à fibres optiques selon la revendication 2, caractérisé en ce que la source de lumière (1) a une largeur de bande spectrale entre 5 et 50 nm.

4.  Transformateur de courant à fibres optiques selon la revendication 1, caractérisé en ce que le miroir (7) à l'extrémité éloignée de la fibre détectrice (5) est conçu en tant que miroir tournant, qui fait tourner le sens de polarisation de la lumière d'un angle total de 90°.

5.  Transformateur de courant à fibres optiques selon la revendication 1, caractérisé en ce que le branchement en Y (3) est construit optiquement de manière intégrée conjointement avec les moyens de polarisation (4).

6.  Transformateur de courant à fibres optiques selon la revendication 1, caractérisé en ce que les moyens de polarisation (4) comprennent une extrémité de la première fibre HB (2a) entrante enroulée en un polarisateur à fibres optiques.

7. Transformateur de courant à fibres optiques selon la revendication 1, caractérisé en ce que la bobine détectrice est construite de l'une des trois manières suivantes:
   - une fibre de verre de biréfringence intrinsèque circulaire élevée est enroulée lâchement autour d'un cylindre creux (12), ou
   - une fibre de verre de biréfringence linéaire faible est torsadée mécaniquement et enroulée lâchement autour d'un cylindre creux (12), ou
   - une fibre de verre dans laquelle la lumière est dirigée selon une trajectoire hélicoïdale, est enroulée lâchement autour d'un cylindre creux (12).

8. Transformateur de courant à fibres optiques selon la revendication 1, caractérisé en ce que la source de lumière (1) est une LED, une SRD ou une LD, qui est chaque fois collée directement à la première fibre HB (2a).

9. Transformateur de courant à fibres optiques selon la revendication 4, caractérisé en ce que le miroir tournant, au sens d'un rotateur de Faraday, comprend un verre optique (10) placé dans un aimant permanent (11), ainsi qu'une optique pour faire converger la lumière passant de la fibre détectrice (5) dans le verre optique (10).

10. Transformateur de courant à fibres optiques selon la revendication 1, caractérisé en ce que les moyens de détection (8) comprennent un branchement en Y avec des polarisateurs aux bras pour analyser les deux états de polarisation de la deuxième fibre HB.

Fig. 1

Fig. 2

Fig. 3

Fig. 4